# EUROPEAN PATENT SPECIFICATION

(11) **EP 3 695 442 B1**
(45) Date of publication and mention of the grant of the patent: **07.07.2021**
(21) Application number: 18789303.7
(22) Date of filing: 09.10.2018
(51) Int. Cl.: H01L 33/48, H01L 33/60, H01L 33/50

(54) **LIGHT EMITTING DEVICE INCLUDING CONVERTER CONFINEMENT**
LICHTEMITTIERENDE VORRICHTUNG MIT WANDLERBEGRENZUNG
DIODE ÉLECTROLUMINESCENTE COMPRENANT UN CONFINEMENT DE CONVERTISSEUR

(30) Priority: 10.10.2017 US 201715729269; 17.01.2018 EP 18152118
(43) Date of publication of application: 19.08.2020
(73) Proprietor: Lumileds LLC, San Jose, CA 95131 (US)
(72) Inventor: MORAN, Brendan, San Jose California 95131 (US); KOSOWSKY, Lex, San Jose California 95131 (US)
(74) Representative: ter Heegde, Paul Gerard Michel
(86) International application number: PCT/US2018/054922
(87) International publication number: WO 2019/074873

(56) References cited:
- WO-A1-2014/081042
- US-A1- 2015 204 494

## Description

### CROSS REFERENCE TO RELATED APPLICATIONS

This application claims the benefit of U.S. Patent Application No. 15/729,269 filed on October 10, 2017, and EP Patent Application No. 18152118.8 filed on January 17, 2018.

### BACKGROUND

The present disclosure relates to light-emitting devices in general, and more particularly, to a light emitting diode (LED) package including a converter confinement. LEDs are commonly used as light sources in various applications. The main functional part of an LED may be a semiconductor chip comprising two injecting layers of opposite conductivity types (p-type and n-type), and a light-emitting active layer for radiative recombination in which injection of carriers takes place. The semiconductor chip is usually placed in a package that provides electrical connections between the semiconductor chip and the outside world, in addition to protection against vibration and thermal damage. In addition to the semiconductor chip, the LED package may also include a light converter, a reflecting element, and various other components. These components may have differing coefficients of thermal expansion, which makes them susceptible to cracking, delamination, and various other types of mechanical damage.

US 2015/204494 A1 discloses a light-emitting device comprising a plurality of light-emitting elements face-down mounted on a substrate, a plurality of structures each including a transparent plate, a phosphor-containing film provided on a lower surface of the transparent plate and a transparent covering layer provided on the lower surface of the transparent plate so as to cover lower and side surfaces of the phosphor-containing film and a white reflector to cover a side surface of the plurality of light-emitting elements and a side surfaces of the transparent covering layer.

Accordingly, the need exists for LED package designs that reduce the likelihood of mechanical damage when elements with different coefficients of thermal expansion are used in the same LED package.

### SUMMARY

A light-emitting device consisting of a light emitting diode (LED) package and a method for making the same are described herein. The light-emitting device includes a substrate and a light-emitting diode (LED) formed on a first surface of the substrate. The LED is arranged to emit a primary light. A fence structure is mounted to a second surface of the substrate. The fence structure includes a plurality of walls arranged to define a cell, a reflective pattern formed on the second surface of the substrate, the reflective pattern including a plurality of lines, each line being at least partially coincident with a different wall of the fence structure. A light-converting structure is disposed on the second surface of the substrate in the cell. The light-converting structure is arranged to convert at least a portion of the primary light to a secondary light having a wavelength that is different from the wavelength of the primary light. A reflective layer is formed on an outer surface of the plurality of walls of the fence, sidewalls of the substrate, and sidewalls of the LED. The reflective element and the light-converting structure are disposed on opposite sides of the walls of the fence structure.

A light-emitting device and a method for making the same are described herein. The method includes forming a plurality of light-emitting diodes on a first surface of a wafer; forming a fence structure including a plurality of walls that are arranged to define a plurality of cells; coupling the fence structure to a second surface of the wafer that is opposite the first surface by aligning each one of the plurality of cells to a different one of the plurality of LEDs; applying a light-converting material on the second surface of the wafer to form a different respective light-converting structure in each of the plurality of cells; longitudinally cutting the walls of the fence structure and portions of the wafer that are coupled to the walls of the fence structure to form a plurality of light-emitting diode (LED) packages; forming a reflective layer on each of the resulting LED packages; and forming a reflective pattern on a second surface of the wafer prior to coupling the fence structure to the second surface of the wafer, the reflective pattern comprising a plurality of reflective lines that substantially match a footprint of the fence structure.

### BRIEF DESCRIPTION OF THE DRAWINGS

FIG. 1A is a cross-sectional side view of an example of a light emitting diode (LED) package, according to aspects of the disclosure which do not fall within the scope of the invention as defined by the claims;
FIG. 1B is top-down view of an example the LED package of FIG. 1;
FIG. 2A is a flowchart illustrating a portion of a process for manufacturing LED packages, according to aspects of the disclosure;
FIG. 2B is a flowchart illustrating another portion of the process for manufacturing LED packages, according to aspects of the disclosure;
FIG. 3A is a top-down view of an example of a fence structure that is formed during a first stage of the process of FIGS. 2A-B, according to aspects of the disclosure;
FIG. 3B is a side-view of the fence structure of FIG. 3A, according to aspects of the disclosure;
FIG. 4A is a top-down view of the fence structure of FIG. 3A during a second stage of the process of FIGS. 2A-B, according to aspects of the disclosure;
FIG. 4B is a cross-sectional side view of the fence structure of FIG. 4A during the second stage of the process of FIGS. 2A-B, according to aspects of the disclosure;
FIG. 5A is a top-down view of a wafer containing a plurality of LEDs formed during a third stage of the process of FIGS. 2A-B, according to aspects of the disclosure;
FIG. 5B is a cross-sectional side view of the wafer of FIG. 5A during the third stage of the process of FIGS. 2A-B, according to aspects of the disclosure;
FIG. 6A is a top-down view of the wafer of FIG. 5A during a fourth stage of the process of FIGS. 2A-B, according to aspects of the disclosure;
FIG. 6B is a cross-sectional side view of the wafer of FIG. 5A during the fourth stage of the process of FIGS. 2A-B, according to aspects of the disclosure;
FIG. 7A is a top-down view of the wafer of FIG. 5A during a fifth stage of the process of FIGS. 2A-B, according to aspects of the disclosure;
FIG. 7B is a cross-sectional side view of the wafer of FIG. 5A during the fifth stage of the process of FIGS. 2A-B, according to aspects of the disclosure;
FIG. 8A is a top-down view of the wafer of FIG. 5A during a sixth stage of the process of FIGS. 2A-B, according to aspects of the disclosure;
FIG. 8B is a cross-sectional side view of the wafer of FIG. 5A during the sixth stage of the process of FIGS. 2A-B, according to aspects of the disclosure;
FIG. 9A is a top-down view of the wafer of FIG. 5A during a seventh stage of the process of FIGS. 2A-B, according to aspects of the disclosure;
FIG. 9B is a cross-sectional side view of the wafer of FIG. 5A during the seventh stage of the process of FIGS. 2A-B, according to aspects of the disclosure;
FIG. 10A is a top-down view of the wafer of FIG. 5A during an eight stage of the process of FIGS. 2A-B, according to aspects of the disclosure;
FIG. 10B is a cross-sectional side view of the wafer of FIG. 5A during the eight stage of the process of FIGS. 2A-B, according to aspects of the disclosure;
FIG. 11A is a top-down view of the wafer of FIG. 5A during a ninth stage of the process of FIGS. 2A-B, according to aspects of the disclosure;
FIG. 11B is a cross-sectional side view of the wafer of FIG. 5A during the ninth stage of the process of FIGS. 2A-B, according to aspects of the disclosure;
FIG. 12A is a top-down view of the wafer of FIG. 5A during a tenth stage of the process of FIGS. 2A-B, according to aspects of the disclosure;
FIG. 12B is a cross-sectional side view of the wafer of FIG. 5A during a tenth stage of the process of FIGS. 2A-B, according to aspects of the disclosure;
FIG. 12C is another cross-sectional side view of the wafer of FIG. 5A during the tenth stage of the process of FIGS. 2A-B, according to aspects of the disclosure;
FIG. 13 is a cross-sectional side view of an LED package during an eleventh stage of the process of FIGS. 2A-B, according to aspects of the disclosure;
FIG. 14A is a cross-sectional side view of an LED package formed as a result of performing the process of FIGS. 2A-B, according to aspects of the disclosure;
FIG. 14B is a top-down view of the LED package of FIG. 14A, according to aspects of the disclosure; and
FIG. 15 is a flowchart of another process for manufacturing LED packages, according to aspects of the disclosure.

### DETAILED DESCRIPTION

Chip-scale packaged (CSP) light emitting diodes (LEDs) have been either offered for sale or commercially announced for several years, most notably from Lumileds TM, Nichia TM, Osram TM, TSMC TM, Toshiba TM, Seoul Semiconductor TM, among others. In most cases, however, these LEDs start as a solderable primary-light (e.g., blue light) LED that is created using wafer-scale high-throughput semiconductor fabrication techniques and packaged together with a light-converting structure and additional packaging materials to create a finished LED package. The purpose behind adding the light-converting structure is to convert the primary light (e.g., blue light) to secondary light (e.g., white light). In some instances, the added packaging and light-converting structure work to direct both the primary light and the secondary light towards the surface of the package. This creates a chip-scale packaged (CSP) light-emitting device which is desirable in space-constrained applications that require secondary optics, such as camera flash lens applications, and automotive headlight applications.

Reliable primary-light CSP LEDs can be achieved with wafer fabrication techniques that allow a transparent growth substrate (e.g., sapphire) to remain intact and become the essential support structure (or volume bulk) of the device. However, the transparent nature of the growth substrate may lead to the somewhat unintentional creation of a 'volume emitter' - which emits the generated primary light (e.g., blue light) in 5 directions (4 sides, 1 top). Accordingly, placing a reflective element such as a thin film metal or thin film distributed Bragg reflector (DBR) on the sidewalls of the substrate after die fabrication can work to prevent the creation of a volume emitter.

If a light-converting structure is placed on top of a primary-light (e.g., blue) LED, another volume emitter is again created as light-converting structures by definition scatter light. To prevent the light-converting structure from acting as a volume emitter, a reflective element (e.g., a reflective film) may be formed on the sides of the light-converting structure. However, doing so may reduce the reliability and/or luminous output of a given LED package when the light-converting structure and the reflective element have different coefficients of thermal expansion (CTEs).

More specifically, typical light-converting structures may include inorganic phosphor particles suspended in an inorganic matrix, and they may have mechanical properties that are dominated by their matrix materials, most commonly silicone. The coefficient of thermal expansion of a typical light-converting structure may be in the order of 200 ppm, whereas thin film reflective elements may have a much lower CTE. For instance, silver (Ag) may have CTE of 20 ppm and a TiO2/AIO2 stack may have a CTE of 7-9 ppm. Accordingly, placing such light-converting structures in intimate contact with typical reflective elements (to produce a confined light source) may result in the reflective elements cracking and flaking off during typical assembly and operational temperature cycles.

One solution to this problem is to provide light-emitting devices with a fence that is arranged to surround the light-converting structures in those devices and provide a physical barrier between the light-converting structures and reflective elements formed on the exterior of the fence. In this regard, according to aspects of the disclosure, a light-emitting device is disclosed that includes a light emitting diode arranged to emit primary light, a light-converting structure, and a fence surrounding the light-converting structure. The fence may be a structure formed of a rigid material that is arranged to separate the light-converting structure from a reflective element (e.g., a reflective side coating) that is formed on the outer surfaces of the fence. The reflective element may have a different coefficient of thermal expansion (CTE) from the light-converting structure. However, because the fence is formed of a rigid material, the fence can withstand the forces resulting from an uneven thermal expansion of the light-converting structure and the reflective element, thereby preventing cracking and delamination of the reflective element which might occur if the reflective element were in direct contact with the light-converting structure.

According to aspects of the disclosure, a method for manufacturing light-emitting diode (LED) packages as disclosed in claim 15 is provided, comprising: forming a plurality of light-emitting diodes (LEDs) on a first surface of a wafer; forming a fence structure including a plurality of walls that are arranged to define a plurality of cells; coupling the fence structure to a second surface of the wafer that is opposite the first surface by aligning each one of the plurality of cells to a different one of the plurality of LEDs; applying a light-converting material on the second surface of the wafer to form a different respective light-converting structure in each of the plurality of cells; and longitudinally cutting the walls of the fence structure and portions of the wafer that are coupled to the walls of the fence structure to form a plurality of light-emitting devices.

One feature of the method for manufacturing light-emitting devices is the addition to the wafer fabrication process of a fence structure that is formed of glass or another material. The fence structure can be chemically or mechanically bonded to the surface of the wafer, and may later be diced or otherwise singulated concurrently with the wafer when the wafer undergoes such a process. Thus, the method for manufacturing light-emitting devices produces chip-scale packaged (CSP) devices whose light generation and source quality/confinement are achieved primarily at the wafer level, thus minimizing any additional process steps following the fabrication of primary-light LEDs.

Examples of different light-emitting devices will be described more fully hereinafter with reference to the accompanying drawings. These examples are not mutually exclusive, and features found in one example can be combined with features found in one or more other examples to achieve additional implementations. Accordingly, it will be understood that the examples shown in the accompanying drawings are provided for illustrative purposes only, and they are not intended to limit the disclosure in any way. Like numbers refer to like elements throughout.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. It will be understood that these terms are intended to encompass different orientations of the element in addition to any orientation depicted in the figures.

Relative terms such as "below" or "above" or "upper" or "lower" or "horizontal" or "vertical" may be used herein to describe a relationship of one element, layer or region to another element, layer or region as illustrated in the figures. It will be understood that these terms are intended to encompass different orientations of the device in addition to the orientation depicted in the figures.

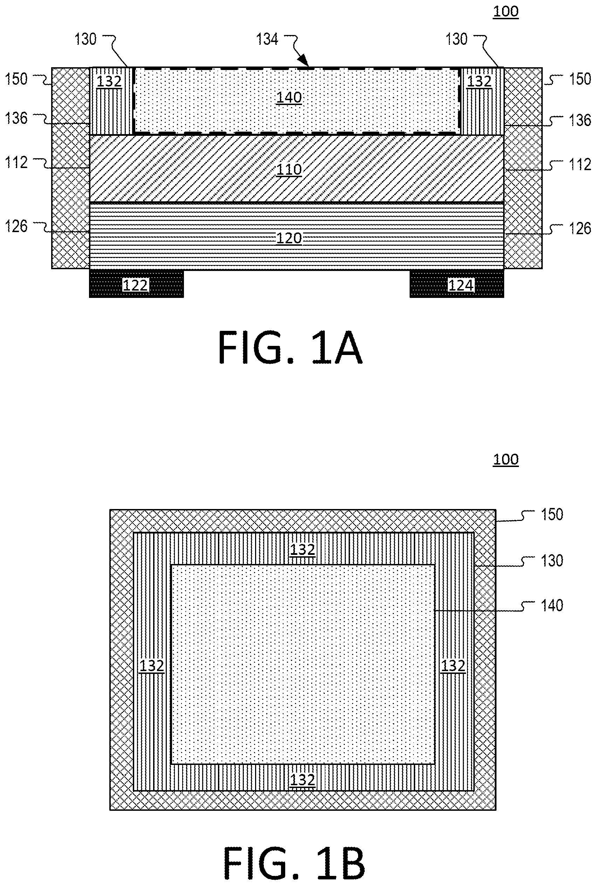

FIG. 1A is a cross-sectional side view of an example of a light-emitting device 100 and FIG. 1B is a top-down view of the light-emitting device 100, according to aspects of the disclosure which do not fall within the scope of the invention as defined by the claims. The light-emitting device 100 includes a substrate 110 having a first surface and a second surface. Formed on the first surface is a light-emitting diode (LED) 120 having contacts 122 and 124. Formed on the second surface is a fence 130 including a plurality of walls 132 that are arranged to define a cell 134 (denoted by the dashed rectangle). Disposed inside the cell 134 is a light-converting structure 140 arranged to convert primary light emitted from the LED 120 to secondary light having a wavelength that is different from the wavelength of the primary light. A reflective element 150 is disposed on the outer surfaces 136 of the fence 130, the edges 126 of the LED 120, and the edges 112 of the substrate 110.

The substrate 110 may include a sapphire substrate in the present example. However, alternative implementations are possible in which the substrate 110 includes a GaAs substrate, a Si substrate, and/or any other suitable type of substrate.

The LED 120 may include any suitable light-emitting semiconductor structure. In some implementations, the LED 120 may include a p-type layer, an n-type layer, and an active layer that are grown epitaxially on the substrate 110 using well-known deposition techniques. The active layer may be disposed between the n-type layer and the p-type layer and may emit light when forward bias is applied to the LED 120 via the contacts 122 and 124. The LED 120 may be formed using various materials, such as indium gallium nitride (InGaN) materials, aluminum gallium indium phosphide (AIGalnP) materials, aluminum gallium arsenide (AIGaAs) materials, or gallium phosphide (GaP) materials, for example.

The fence 130 may be disposed between the light-converting structure 140 and the reflective element 150. The fence 130 may confine the light-converting structure 140 and act as a physical barrier between the light-converting structure 140 and the reflective element 150. In this regard, the fence 130 may separate the light-converting structure 140 from the reflective element 150 and compensate for any mismatch between their respective coefficients of thermal expansion (CTE). More particularly, when the light-converting structure 140 has a CTE that is many times higher than the CTE of the reflective element 150 (e.g., 5 times higher, 10 times higher, 15 times higher, etc.), the fence 130 may prevent any cracking and delamination of the reflective element 150 that might otherwise occur if the reflective element 150 were to be formed directly on the light-converting structure 140.

The fence 130, in the present example, may be formed of glass and it may have a height in the order of 100-120um. However, the present disclosure is not limited to any specific dimensions or material for the fence 130. Alternative implementations are possible in which the fence 130 is formed of any other suitable type of material and has any suitable height and/or other dimensions. For example, in some implementations, the fence 130 may be formed of aluminum, anodized aluminum, silicon and on and/or any other suitable type of metal. Additionally or alternatively, in some implementations, the fence 130 may be formed of a semiconductor material, such as silicon. In some implementations, the fence 130 may be formed of a metal that is covered with a dielectric coating. Additionally or alternatively, in some implementations, the fence 130 may be formed of a semiconductor material, such as silicon, that is covered with a dielectric coating. Additionally or alternatively, in some implementations, the fence may be formed of a ceramic material, such as Aluminum Oxide, Aluminum Nitride, Boron Nitride. Additionally or alternatively, in some implementations, the fence 130 may be formed of a material having sufficient rigidity to withstand the forces generated as a result of the light-converting structure 140 expanding due to an increase in temperature of the light-emitting device 100 without changing its shape. Additionally or alternatively, the fence 130 may be formed of any metallic material, ceramic material, and/or any other suitable type of material. Additionally or alternatively, in some implementations, the fence 130 may be formed of high-temperature stable polymers, such as LCP, or Polyimide (when coated with a reflective material).

The light-converting structure 140 may be formed of any suitable type of material. For example, the light-converting structure 140 may be formed of a light-converting material suspended in a matrix material. In some implementations, the light-converting material may include any suitable type of phosphor, such as a yellow phosphor, a red phosphor, a blue phosphor, etc. The matrix material may include a silicon binder, glass, and/or any other suitable type of material. Additionally or alternatively, in some implementations, the light-converting structure 140 may be formed of a light-converting material that is sintered, rather than being suspended in a matrix material.

The reflective element 150 may include a reflective film formed by coating the sides of the light-emitting device 100 with one or more materials. In some implementations, the reflective element 150 may be formed by coating the sides of the LED package with silver or another metal, such as aluminum. Additionally or alternatively, the reflective element 150 may be formed by coating the sides of the light-emitting device 100 with one or more dielectric materials, such as SiO₂, TiO₂, or Si3N4, AlO₂ . Additionally or alternatively, the reflective element 150 may be a distributed Bragg reflector (DBR) including an alternating stack of materials having different refractive indexes (e.g., a SiO₂ TiO₂ stack).

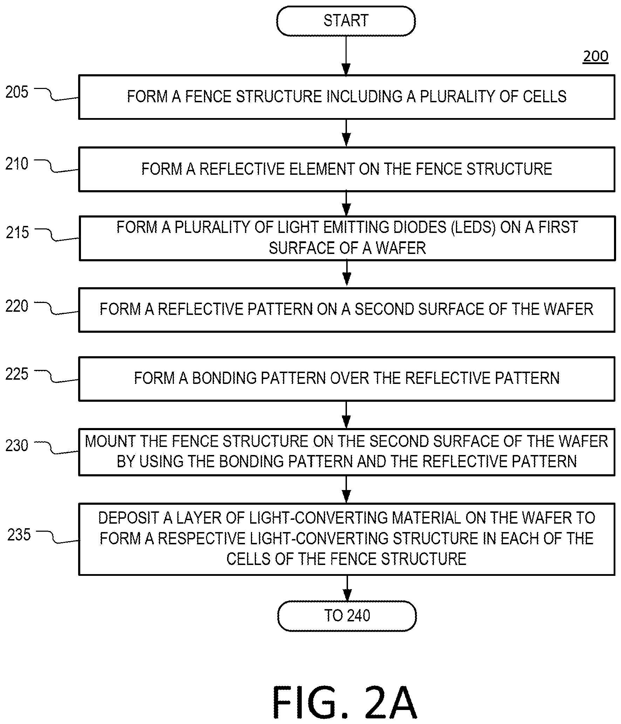

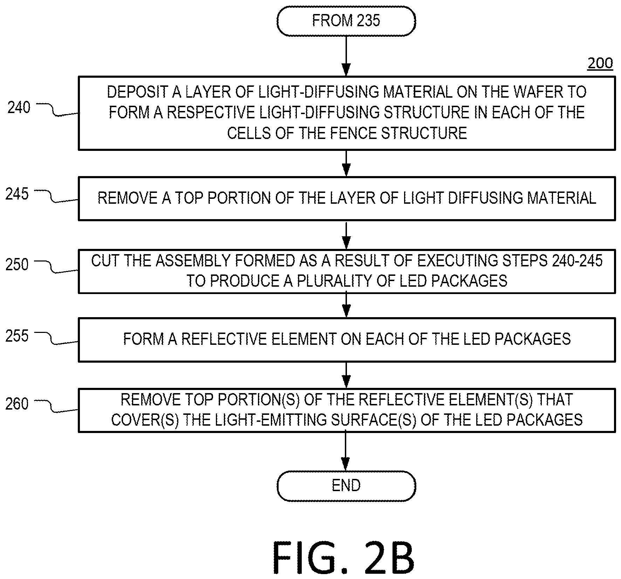

FIG. 2 is a flowchart of an example of a process 200 for manufacturing a light-emitting device, according to aspects of the disclosure.

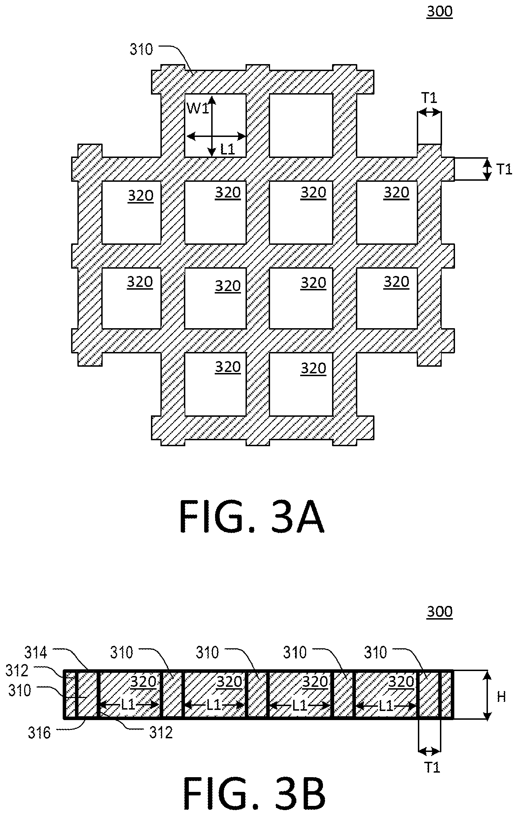

At step 205, a fence structure 300 is formed. As illustrated in FIGS. 3A-B, the fence structure 300 includes a plurality of walls 310 that are arranged to form cells 320. In some implementations, the height H of any of the walls 310 may be in the range of 100-120 urn. Additionally or alternatively, in some implementations, the thickness T1 of any of the walls 310 may be in the range of 3-30 microns, and it may be dependent on the mechanical robustness of the material used to form the fence structure 300.

In some implementations, the fence structure 300 may be formed of photoimegable glass, such as the Foturon TM glass manufactured by Schott Glass TM. The fence structure 300 may be formed by etching the cells 320 into a glass sheet, using any suitable etching technique, such as photo patterning or wet etching, for example. Additionally or alternatively, in some implementations, the fence structure 300 may be formed of a metal, such as aluminum, anodized aluminum, and/or another suitable metal. Additionally or alternatively, in some implementations, the fence structure 300 may be formed of a semiconductor material, such as silicon. Additionally or alternatively, in some implementations, the fence structure 300 may be formed of quartz, machinable ceramic, moldable ceramic, and/or photoimegeable ceramic. Additionally or alternatively, in some implementations, the fence structure 300 may be made of a material capable of forming smooth surfaces when it is cut or etched. In this regard, the present disclosure is not limited to any particular material and/or process for manufacturing the fence structure 300. Although in the present example the fence structure 300 is a grid including a plurality of rectangular cells, alternative implementations are possible in which the fence structure 300 may include any suitable shape of cells, such as round cells, octagonal cells, hexagonal cells, etc.

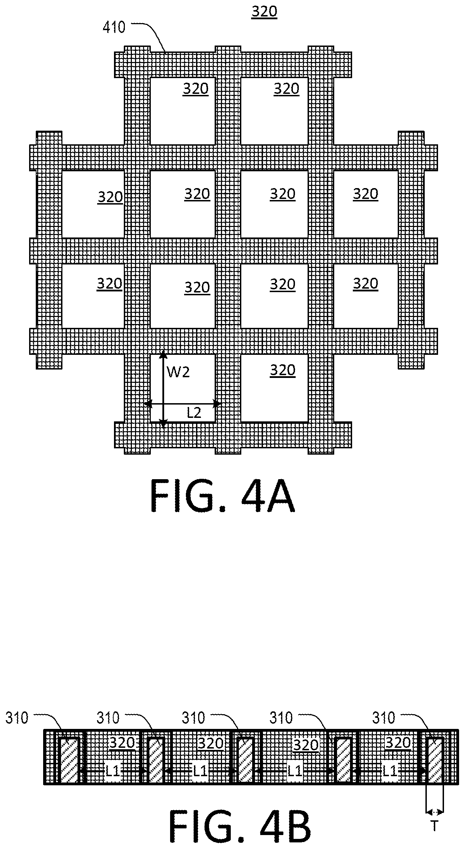

At step 210, a reflective element 410 is formed on the fence structure 300. As illustrated in FIGS. 4A-B, the reflective element 410 may be a reflective film that is formed by coating the walls 310 of the fence structure 300 with one or more dielectric and/or conductive materials, such as SiO₂, TiO₂, Si₃N₄, Ag, or Al. Additionally or alternatively, in some implementations, the reflective element 410 may be a distributed Bragg reflector (DBR) including an alternating stack of materials having differing refractive indices. For instance, in one implementation, the reflective element 410 may include an alternating stack of SiO₂ and TiO₂ layers. In the present example, the side surfaces 312 and the top surface 314 are covered by the reflective element 410. The reflective element 410 may be formed using atomic layer deposition (ALD), chemical vapor deposition (CVD), and/or any other suitable deposition technique. Although in the present example of the bottom surfaces 316 of the walls 310 are not covered by the reflective element 410, alternative implementations are possible in which the bottom surfaces 316 are also covered.

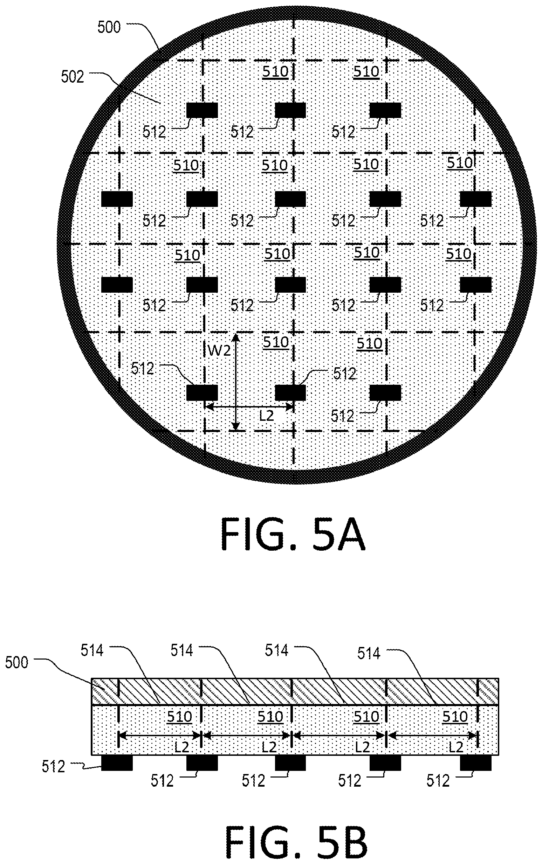

At step 215, a plurality of light emitting diodes (LEDs) 510 is formed on a first surface 502 of a wafer 500 (FIGS. 5A-B). Each LED 510 may include any suitable type of light-emitting semiconductor device. For example, each LED 510 may include at least a p-type layer, an n-type layer, and an active layer that are grown on the wafer 500 using well-known deposition techniques. Although the LEDs 510 are integral with one another, alternative implementations are possible in which the LEDs 510 are separate. The LEDs 510 may be formed using various materials, such as indium gallium nitride (InGaN) materials, aluminum gallium indium phosphide (AIGalnP) materials, aluminum gallium arsenide (AIGaAs) materials, or gallium phosphide (GaP) materials, for example.

Each LED 510 may have a width W2 that is larger than the width W1 of the cells 320. Additionally or alternatively, each LED 510 may have a length L2 that is larger than the length L1 of the cells 320. Additionally or alternatively, each LED 510 may have a top surface 514 that is larger than the area of the cells 320. In this regard, when the fence structure 300 is mounted on the wafer 500, each cell 320 may be placed above the top surface 514 of a respective LED 510 without extending outside of that top surface.

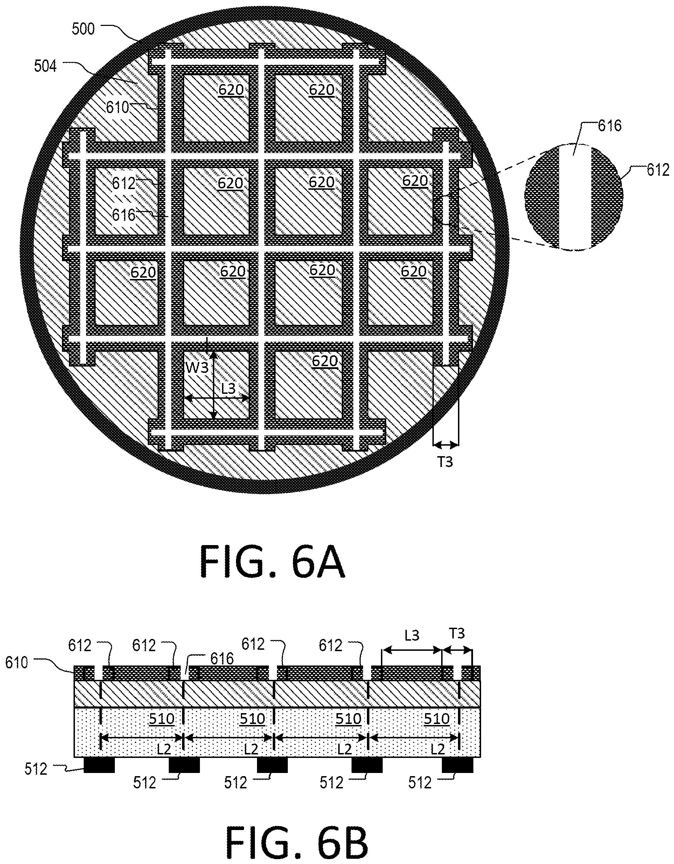

At step 220, a reflective pattern 610 is formed on a second surface 504 of the wafer 500. As illustrated in FIGS. 6A-B, the reflective pattern 610 may include a plurality of reflective lines 612 arranged to form cells 620. Any of the reflective lines 612 may be formed of one or more conductive and/or dielectric materials, such as SiO₂, TiO₂, Si3N4, Ag, or Al. Additionally or alternatively, in some implementations, any reflective line 612 may include a distributed Bragg reflector (DBR) comprising an alternating stack of materials having differing refractive indices. For example, any of the reflective lines 612 may include an alternating stack of SiO₂ and TiO₂ layers.

In some implementations, the reflective pattern 610 may match the footprint of the fence structure 300. The footprint of the fence structure 300 may have the same or similar profile as the top surface of the fence structure 300, which is shown in FIG. 3A. When the fence structure 300 is placed over the reflective pattern 610 (see step 230 below), each of the reflective lines 612 may become situated under a different wall 310 of the fence structure 300, thereby preventing light from travelling through the bottom surfaces 316 of the walls of the fence structure.

In some implementations, one or more of the reflective lines 612 may include a respective light-transmissive portion 616 that extends along the lines' respective lengths. The light transmissive portion 616 in each line may be sandwitched between two reflective portions of the line, as shown. The light-transmissive portion 616 may be provided to allow laser light to travel through the reflective pattern 610. As is further discussed below, the laser light may be used to cut the wafer and/or the fence structure 300. Additionally or alternatively, in some implementations, the reflective lines 612 may be solid (thus lacking a light-transmissive portion).

In some implementations, each of the cells 620 may have a width W3 that is substantially the same as the width W1 of the cells 320. Additionally or alternatively, each of the cells 620 may have a length L3 that is substantially the same the length L1 of the cells 320. Additionally or alternatively, each of the lines 612 may have a thickness T3 that is substantially the same to the thickness T1 of the walls 310 of the fence structure 300.

Although in the present example the reflective pattern 610 has dimensions that are substantially the same to the dimensions of the fence grid, alternative implementations are possible in which one or more of the dimensions of the pattern 610 (e.g., cell width, cell length, line thickness, etc.) are different from those of the fence structure 300. For example, in some implementations, the thickness T3 of the lines 712 may be lower (or greater) than that the thickness T1 of the walls 310 of the fence structure 300. As another example, the width W3 of the cells 620 may be lower (or greater) than the width W1 of the cells 320. As yet another example, the length L3 of the cells 620 may be lower (or greater) than the length L1 of the cells 320.

In some implementations, the reflective pattern 610 may only partially match the footprint of the fence structure 300. In such instances, one or more of the reflective lines 612 may be only partially situated underneath the walls 310 of the fence structure 300 when the fence structure 300 is placed on the wafer 500 (see step 230 below). Additionally or alternatively, in such instances, one or more of the reflective lines 612 may not overlap at all with the walls 310. Stated succinctly, in some implementations, at least one of the lines 612 may be only partially coincident with a given wall 310 (or not coincident with any of the walls 310) when the fence structure 300 is mounted on the wafer 500.

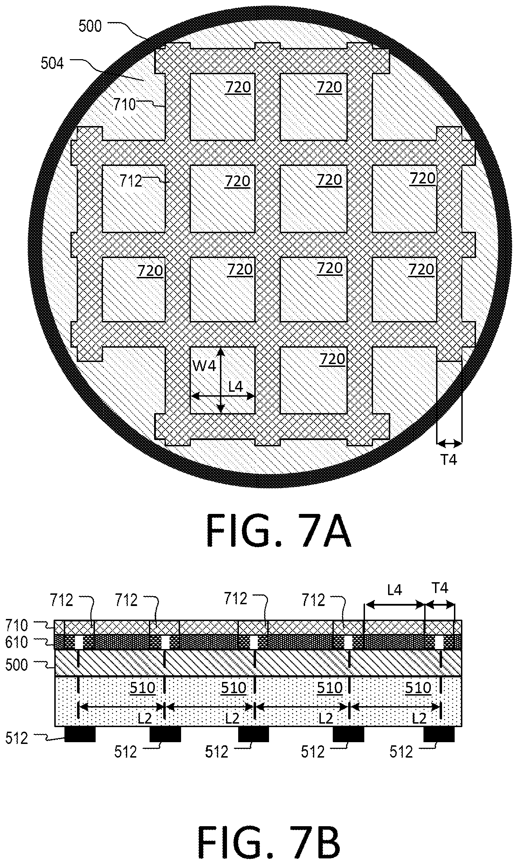

At step 225, a bonding pattern 710 is formed over the reflective pattern 610. As illustrated in FIGS. 7A-B, the bonding pattern 710 may include a plurality of lines 712 arranged to form cells 720. Any of the lines 712 may be formed of a material capable of facilitating the bonding between the fence structure 300 and the wafer 500. For example, in some implementations, one or more of the lines 712 may be formed of Silicone, SiO₂, Al₂O₃, and/or any other suitable material. In some implementations, the bonding pattern 710 may match the footprint of the fence structure. The footprint of the fence structure 300 may have the same or similar profile as the top surface of the fence structure 300, which is shown in FIG. 3A. When the fence structure 300 is placed over the bonding pattern 710, each of the lines 712 may become (completely or partially) situated under a different wall 310 of the fence structure 300, thereby facilitating the bonding of that wall to the surface 504 of the wafer 500 (see step 230 below).

In some implementations, each of the cells 720 may have a width W4 that is substantially the same as the width W1 of the cells 320. Additionally or alternatively, each of the cells 720 may have a length L4 that is substantially the same as the length L1 of the cells 320. Additionally or alternatively, each of the lines 712 may have a thickness T4 that is substantially the same to the thickness T1 of the walls 310 of the fence structure 300.

Although in the present example the first pattern 710 has dimensions that are substantially the same as those of the fence structure 300, alternative implementations are possible in which one or more dimensions of the bonding pattern 710 (e.g., cell width, cell length, line thickness, etc.) are different from those of the fence structure 300. For example, in some implementations, the thickness T4 of the lines 712 may be lower (or greater) than that the thickness T1 of the walls 310 of the fence structure 300. As another example, the width W4 of the cells 720 may be lower (or greater) than the width W1 of the cells 320. As yet another example, the length L4 of the cells 720 may be lower (or greater) than the length L1 of the cells 320.

In some implementations, the bonding pattern 710 may only partially match the footprint of the fence structure 300. In such instances, one or more of the lines 712 may be only partially situated underneath the walls 310 of the fence structure 300 when the fence structure 300 is placed on the wafer 500 (see step 230 below). Additionally or alternatively, in such instances, one or more of the lines 712 may not overlap at all with the walls 310. Stated succinctly, in some implementations, at least one of the lines 712 may be only partially coincident with a given wall 310 (or not coincident with any of the walls 310) when the fence structure 300 is mounted on the wafer 500.

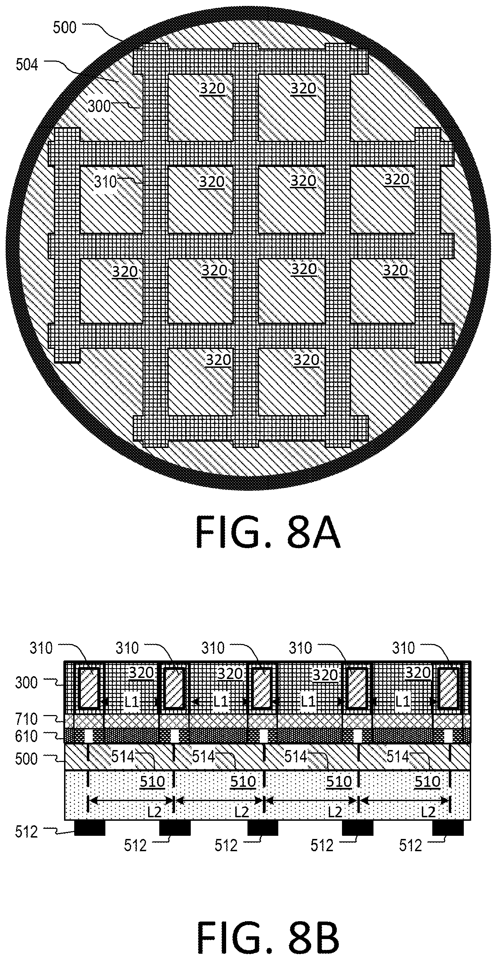

At step 230, the fence structure 300 is mounted on the surface 504 of the wafer 500. As illustrated in FIGS. 8A-B, the fence structure 300 may be placed onto the bonding pattern 710, such that each of the walls 310 is aligned with a different one of the lines 712. As a result, each of the lines 712 of the bonding pattern 710 may remain under a different wall 310 of the fence structure 300. Furthermore, each of the lines 712 may extend along the length of the wall 310 it is situated under. Similarly, each of the reflective lines 612 of the reflective pattern 610 may remain under a different wall 310 of the fence structure 300, as well. Furthermore, just like the lines 712, each of the reflective lines 612 of the reflective pattern 610 may also extend along the length of the wall 310 it is situated under.

The fence structure 300 may be bonded to the surface 504 of the wafer 500 using any suitable type of bonding process, such as thermionic bonding, ultrasonic bonding, and/or any traditional wafer bonding technique. In some implementations, each of the cells 320 may become aligned with a different one of the LEDs 510, when the fence structure 300 is mounted on the surface 504 of the wafer 500. As a result, each of the cells 320 may completely overlap with the top surface 514 of a different LED 510, as shown. In some implementations, the alignment between the cells 320 and the LEDs 510 may be achieved by using a wafer liner when mounting the fence structure 300 on the surface 504 of the wafer 500. For example, a wafer bond liner manufactured by EVG TM of Florian am Inn, Austria may be used.

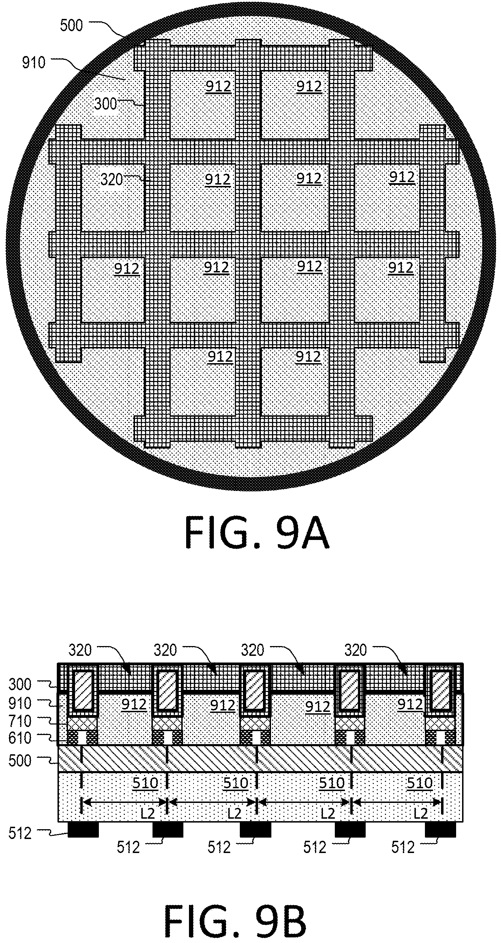

At step 235, a layer of light-converting material 910 is deposited on the surface 504 of the wafer 500 to form a different light-converting structure 912 in each of the cells 320 of the fence structure 300. As illustrated in FIGS. 9A-B, each of the cells 320 may be filled only partially with the light-converting material 910. However, alternative implementations are possible in which each of the cells 320 is filled completely with the light-converting material 910.

In some implementations, the light-converting material 910 may include a phosphor suspended in a matrix material. The phosphor may include a yellow phosphor, a red phosphor, a blue phosphor, etc. The matrix material may include a silicon binder, glass, and/or any other suitable type of material. Additionally or alternatively, in some implementations, each light-converting structure 912 may be formed of a light-converting material that is sintered, rather than being suspended in a matrix material.

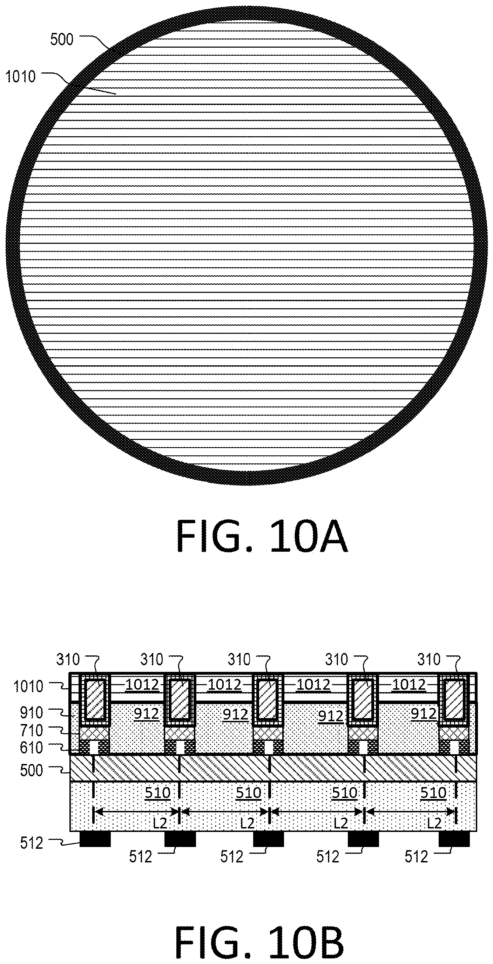

At step 240, a layer of light-diffusing material 1010 is deposited over the layer of light-converting material 910 to form a plurality of light-diffusing structures 1012. The light-diffusing material may include TiO₂, and/or any other suitable type of material. As illustrated in FIGS. 10A-B, each light diffusing structure may be situated in a different cell 320 of the fence structure 300. Although in the present example the light-diffusing material 1010 completely fills the remaining space in the cells 320, while also overflowing the fence structure 300, alternative implementations are possible in which the remaining space in each of the cells 320 is filled only partially with the light diffusing materials. In such instances, room may be left in each of the cells 320 for applying another layer of material. This material can be used to further condition or filter secondary light that is emitted from the light-converting structures 912 to achieve a desired luminous output.

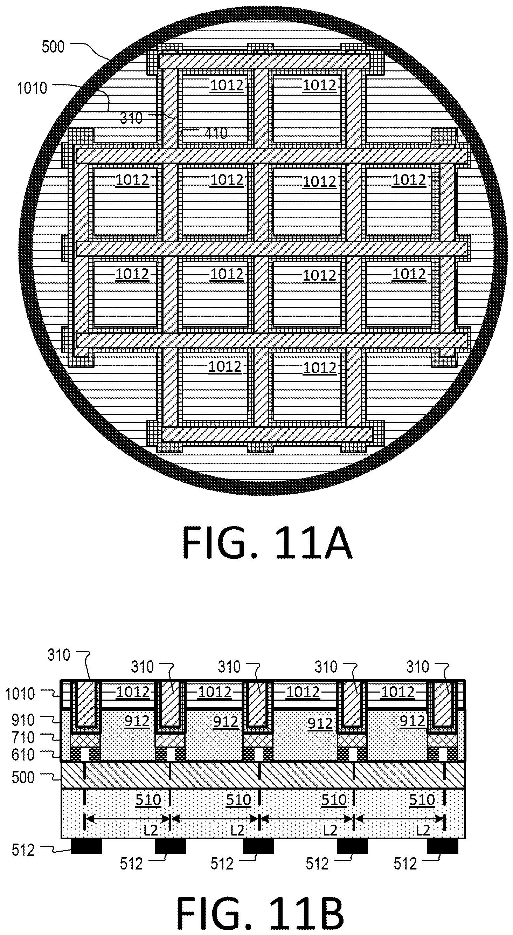

At step 245, the top portion of the light-diffusing material 1010 is removed to achieve a desirable thickness of the light-diffusing structures 1012. In some implementations, together with removing the top portion of the layer of light-diffusing material 1010, the top portion of the reflective element 410 and/or the top portion of the walls 310 of the fence structure 300 may also be removed, as shown in FIGS. 11A-B. The top portion of the light-diffusing material 1010 may be removed using any suitable technique, such as back grinding, fly cutting, polishing or abrasion blasting.

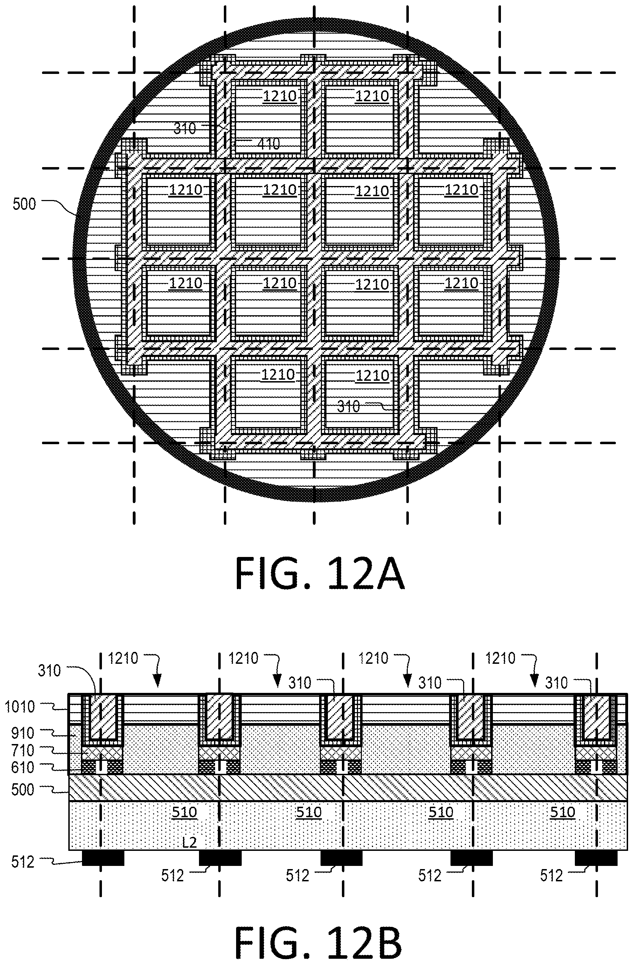

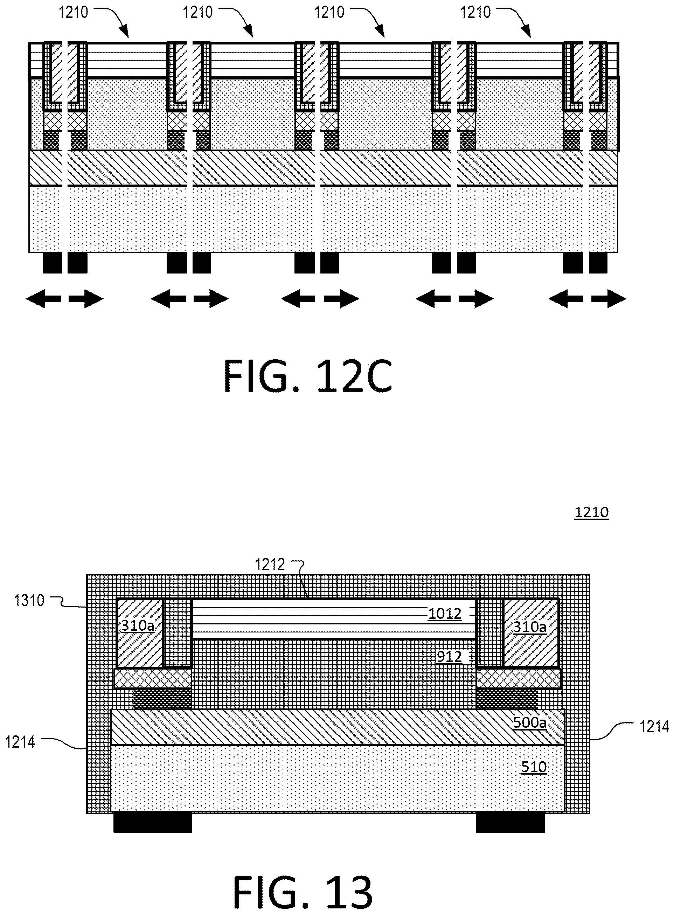

At step 250, the assembly formed by executing steps 204-245 is cut to produce a plurality of LED packages 1210. Cutting the assembly may include longitudinally cutting through the walls 310 of the fence structure 300, as indicated by the dashed lines in FIG. 12A. Additionally or alternatively, cutting the assembly may include cutting through the portions of the wafer 500 that are coupled to the walls 310 (e.g., the portions of the wafer 500 that are situated directly underneath the wall 310), as indicated by the dashed lines in FIG. 12B. The wafer 500 and the walls 310 of the fence structure may be cut concurrently with one another. After the wafer 500 and the fence structure 300 are cut, the LED packages 1210 may be separated from each other, as shown in FIG. 12C. The separation may be performed using stretch-tape and/or any other suitable technique.

To clarify the cutting of the fence structure 300, it is worth noting that each wall 310 of the fence structure 300 includes a plurality of sections, wherein each section separates two neighboring cells 320. When the walls 310 are longitudinally cut, each such section may be split into two fractions (e.g., halves), such that one fraction remains on one LED package 1210 while the other fraction may remain in another LED package 1210. Each fraction may essentially become part of a different fence in a different LED package 1210. These fences may be individual confinement structures that are separated from the fence structure 300 when the fence structure 300 is cut and they may be used to contain the light-converting structures 912 and/or the light-diffusing structures 1012.

In some implementations, the walls 310 of the fence structure 300 and the wafer 500 may be cut concurrently and/or simultaneously. For example, the fence structure and the wafer 500 may be cut using a laser. In such instances, laser incisions may be performed along the light-transmissive portions 616 of the reflective lines 612, which may permit the laser light to travel across the reflective pattern 610 and dissipate in either the walls 310 or the wafer 500.

Additionally or alternatively, in some implementations, the walls of the fence structure 300 and the wafer 500 may be cut using another process. For example, in some implementations, the fence structure 300 and the wafer 500 may be stealth-diced at different depths. As another example, a saw may be used to cut through the fence structure 300 and expose the surface 504 of the wafer 500, after which laser singulation may be used to form smooth cuts through the wafer 500. As another example, a saw may be used to cut through the fence structure 300 and expose the surface 504 of the wafer 500, after which a laser may be used to cut the wafer 500. In this regard, the present disclosure is not limited to any specific technique for cutting the wafer 500 and the fence structure 300 to form the plurality of LED packages 1210.

At step 255, a reflective element 1310 is formed on each of the resulting LED packages 1210. As illustrated in FIG. 13, the reflective element 1310 may be a reflective film that is formed by coating the top surface 1212 (e.g., light-emitting surface), and the outer side surfaces 1214 of the LED package 1210 with a dielectric material, such as SiO₂, TiO₂, Si₃N₄. In some implementations, the reflective element 1310 may be a Distributed Bragg Reflector (DBR). More particularly, the reflective element 1310 may include an alternating stack of SiO₂ and TiO₂ layers that are formed over one another. As can be readily appreciated, the reflective element 1310 may be formed of a dielectric material to avoid shorting the LED 510 in each of the LED packages 1210. However, alternative implementations are possible in which the reflective element is formed of a metal such as aluminum or silver, provided that an insulating coating is applied beforehand on the sides of each LED 510.

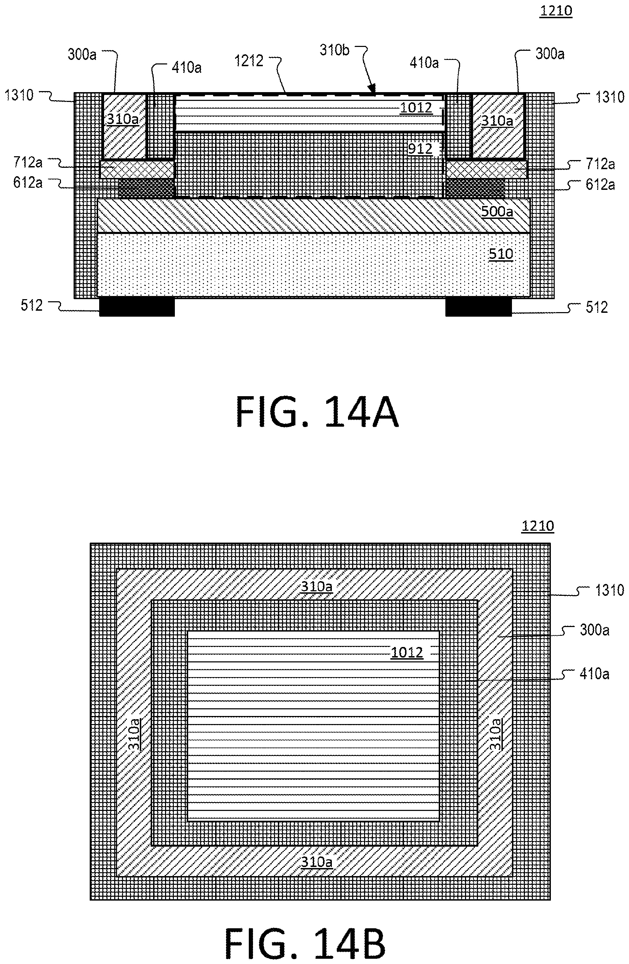

At step 260, the top portion of the reflective element 1310 is removed, as shown in FIG. 14A, to expose the light-emitting surface 1212 of the LED package 1210. The top portion of the reflective element 1310 may be removed using any suitable process, such as back grinding, polishing, fly cutting, or abrasion blasting, for example.

The process 200 is provided as an example, only. One or more of the steps in the process 200 may be omitted. For example, in some implementations, step 220 may be omitted from the process 200. In such instances, no reflective pattern will be formed on the wafer 500. Additionally or alternatively, in some implementations, step 225 may be omitted from the process 200. In such instances, no bonding pattern will be formed on the wafer 500. Additionally or alternatively, in some implementations, step 240 may be omitted from the process 200. In such instances, no light-diffusing structures will be formed above the light-converting structures 912. Although in the present example, the fence structure 300 is a rectangular grid, alternative implementations are possible in which at least some of the walls 310 of the fence structure are curved. In such instances, at least some of the lines 612 of the reflective pattern 610 may also have substantially the same curvature as the walls 310 in order for the reflective pattern 610 to match the footprint of the fence structure 300. Furthermore, in such instances, at least some of the lines 712 of the bonding pattern 710 may also have substantially the same curvature as the walls 310 in order for the bonding pattern 710 to match the footprint of the fence structure 300.

FIGS. 14A-B depict an example an LED package 1210 that is produced by performing the process 200 of FIGS. 2A-B. The LED package 1210 includes a substrate 500a. The substrate 500a is essentially a portion of the wafer 500 that is separated when the wafer 500 is cut. Disposed on a first surface of the substrate is an LED 510 that is arranged to emit primary light. Formed on a second surface of the substrate is a fence 300a. The fence 300a is a portion of the fence structure 300 that is separated when the fence structure 300 is cut. As illustrated, the fence 300a includes a plurality of walls 310a that define a cell 310b (denoted by the dashed rectangle). The cell 310b is aligned with the LED 510. In this regard, the cell which is wholly contained within the second surface of the substrate 500a and no portion of it extends over the edges of the LED 510. Disposed inside the cell is a light-converting structure 912 that is configured to convert primary light emitted from the LED 510 into secondary light having a different wavelength than the primary light. Disposed in the cell above the light-converting structure 912 is a light-diffusing structure 1012 that is configured to diffuse the secondary light. Furthermore, as illustrated, a reflective element 410a may be disposed on the interior surfaces of the walls 310a. The reflective element 410a may be a portion of the reflective element 410 that is separated when the fence structure 300 is cut.

Each of the lines 612a is a portion of a given line 612 that is separated when the wafer 500 is cut. In this regard, the lines 612 define a pattern that at least partially matches the footprint of the fence 300a. This pattern is essentially a portion of the reflective pattern 610 that is separated when the wafer 500 is cut. The footprint of the fence 300a may have the same or similar profile as the top surface of the fence 300a, which is shown in FIG. 14b. Each of the lines 612 may be disposed at least partially underneath a different wall 310 of the fence 300a, as shown.

Each of the lines 712a is a portion of a given line 712 that is separated when the wafer 500 is cut. In this regard, the lines 712 define a pattern that at least partially matches the footprint of the fence 300a. This pattern is essentially a portion of the bonding pattern 710 that is separated when the wafer 500 is cut. Each of the lines 712 may be disposed at least partially underneath a different wall 310 of the fence 300a, as shown.

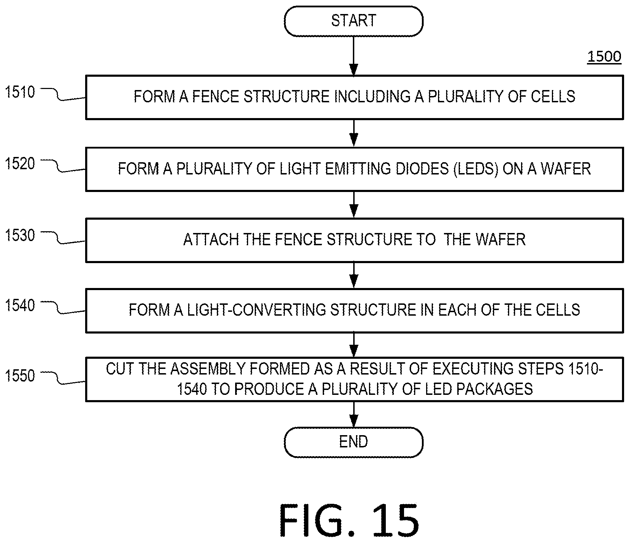

FIG. 15 is a flowchart of an example of a process 1500 for manufacturing light emitting diodes (LEDs), according to aspects of the disclosure which do not fall within the scope of the invention as defined by the claims. At step 1510, a fence structure is formed. The fence structure may be the same or similar to the fence structure 300, and it may include a plurality of walls that are arranged to define a set of cells. At step 1520, a plurality of LEDs is formed on a first surface of a wafer. In some implementations, the LEDs may be the same or similar to the LEDs 510, and the wafer may be similar to the wafer 500. Furthermore, in some implementations the order of steps 1510 and 1520 can be reversed or they may be performed concurrently. At step 1530, the fence structure is bonded to a second surface of the wafer that is opposite to the first surface. As a result of the bonding, each of the cells in the fence structure may be aligned with a different one of the LEDs on the first surface of the wafer. In some implementations, step 1530 may be performed in the same or similar manner similar to step 230 of the process 200. At step 1540, light-converting material is applied in each of the cells of the fence structure to form a light-converting structure. In some implementations, step 1540 may be performed in the same or similar manner as step 235 of the process 200. At step 1550, the assembly formed as a result of executing steps 1510-1540 is cut to produce a plurality of LED packages. Step 1550 may be the same or similar to step 250. After the wafer is cut and the LED packages are separated, a reflective film may be optionally formed on the sides of each package to produce a finished product that is the same or similar to the light-emitting device 100, shown in FIGS. 1A-B.

FIGS. 1-15 are provided as an example only. At least some of the steps discussed with respect to these figures can be arranged in different order, combined, and/or altogether omitted. In this regard, it will be understood that the provision of the examples described herein, as well as clauses phrased as "such as," "e.g.", "including", "in some aspects," "in some implementations," and the like should not be interpreted as limiting the disclosed subject matter to the specific examples.

The present invention is defined by the appended claims.

## Claims

1. A light-emitting device (1210), comprising:
a substrate (500a);
a light-emitting diode (LED 510) formed on a first surface of the substrate (500a), the LED (510) being arranged to emit a primary light;
a fence structure (300a) mounted to a second surface of the substrate (500a), the fence structure (300a) including a plurality of walls (310a) arranged to define a cell (310b), a reflective pattern (610) formed on the second surface of the substrate (500a), the reflective pattern (610) including a plurality of lines (612, 612a), each line (612, 612a) being at least partially coincident with a different wall (310a) of the fence structure (300a);
a light-converting structure (912) disposed on the second surface of the substrate (500a) in the cell (310b), the light-converting structure being arranged to convert at least a portion of the primary light to a secondary light having a wavelength that is different from the wavelength of the primary light; and
a reflective layer (1310) formed on an outer surface of the plurality of walls (310a) of the fence structure (300a), sidewalls of the substrate (500a), and sidewalls of the LED (510), such that the reflective layer (1310) and the light-converting structure (912) are disposed on opposite sides of the walls (310a) of the fence structure (300a).

2. The light-emitting device of claim 1, wherein the fence structure (300a) is formed of at least one of a glass material, a metal material, a polymer material, and a ceramic material

3. The light-emitting device of claim 1, wherein each of the plurality of walls (310a) of the fence structure (300a) is formed adjacently to a different edge of the substrate (500a).

4. The light-emitting device of claim 1, wherein the reflective layer (1310) comprises a film of inorganic reflective material.

5. The light-emitting device of claim 1, wherein the fence structure (300a) is mounted to the second surface of the substrate (500a) via a bonding pattern (710) that at least partially matches a footprint of the fence structure (300a)

6. The light-emitting device of claim 1, further comprising a light-diffusing structure disposed in the cell (310b) the light-diffusing structure being arranged to diffuse secondary light that is emitted from the light-converting structure (912)

7. The light-emitting device of claim 1, further comprising a contact (512) formed on the LED (510).

8. The light emitting device of claim 1, wherein a bonding pattern (710) is formed on the reflective lines (612, 612a) and wherein the fence structure (300a) is mounted to the bonding layer (710).

9. The light-emitting device of claim 8, wherein the bonding pattern has a width that is greater than a width of the reflective lines (612, 612a).

10. The light-emitting device of claim 8, wherein the fence structure (300a) is formed of at least one of a glass material, a metal material, a polymer material, and a ceramic material.

11. The light-emitting device of claim 8, wherein each of the plurality of walls (310a) of the fence structure (300a) is formed adjacently to a different edge of the substrate (500a).

12. The light-emitting device of claim 8, wherein the reflective element (410a) or the reflective layer (1310) comprises a film of inorganic reflective material

13. The light-emitting device of claim 8, further comprising a light-diffusing structure disposed in the cell (310b), the light-diffusing structure being arranged to diffuse secondary light that is emitted from the light-converting structure (912)

14. The light-emitting device of claim 8, further comprising a contact (512) formed on the LED (510).

15. A method for manufacturing the light-emitting device according to one of the claims 1 to 14, the method comprising forming a plurality of light-emitting diodes (LEDs 510) on a first surface (502) of a wafer (500);
forming a fence structure (300) including a plurality of walls (310) that are arranged to define a plurality of cells (320); coupling the fence structure (300) to a second surface of the wafer (500) that is opposite the first surface by aligning each one of the plurality of cells (320) to a different one of the plurality of LEDs (510);
applying a light-converting material on the second surface of the wafer (500) to form a different respective light-converting structure (912) in each of the plurality of cells (320); longitudinally cutting the walls (310) of the fence structure (300) and portions of the wafer that are coupled to the walls (310) of the fence structure (300) to form a plurality of light emitting devices;
forming a reflective layer (1310) on each of the light emitting device;
and
forming a reflective pattern (610) on a second surface (504) of the wafer (500) prior to coupling the fence structure (300) to the second surface of the wafer (500), the reflective pattern (610) comprising a plurality of reflective lines (612, 612a) that substantially match a footprint of the fence structure (300).

## Patentansprüche

1. Lichtemittierendes Bauelement (1210), umfassend:
ein Substrat (500a),
eine Leuchtdiode (LED 510), die auf einer ersten Oberfläche des Substrats (500a) gebildet ist, wobei die LED (510) dazu eingerichtet ist, ein primäres Licht zu emittieren,
eine Umfriedungsstruktur (300a), die auf eine zweite Oberfläche des Substrats (500a) montiert ist, wobei die Umfriedungsstruktur (300a) mehrere Wandungen (310a) beinhaltet, die dazu eingerichtet sind, eine Zelle (310b) zu definieren, wobei ein reflektierendes Muster (610) auf der zweiten Oberfläche des Substrats (500a) gebildet ist, wobei das reflektierende Muster (610) mehrere Linien (612, 612a) beinhaltet, wobei jede Linie (612, 612a) zumindest teilweise mit einer anderen Wandung (310a) der Umfriedungsstruktur (300a) zusammentrifft,
eine Lichtumwandlungsstruktur (912), die auf der zweiten Oberfläche des Substrats (500a) in der Zelle (310b) angeordnet ist, wobei die Lichtumwandlungsstruktur dazu eingerichtet ist, zumindest einen Teil des primären Lichts in ein sekundäres Licht mit einer Wellenlänge umzuwandeln, die sich von der Wellenlänge des primären Lichts unterscheidet, und
eine reflektierende Schicht (1310), die auf einer Außenoberfläche der mehreren Wandungen (310a) der Umfriedungsstruktur (300a), Seitenwandungen des Substrats (500a) und Seitenwandungen der LED (510) gebildet ist, so dass die reflektierende Schicht (1310) und die Lichtumwandlungsstruktur (912) an gegenüberliegenden Seiten der Wandungen (310a) der Umfriedungsstruktur (300a) angeordnet sind.

2. Lichtemittierendes Bauelement nach Anspruch 1, wobei die Umfriedungsstruktur (300a) aus mindestens einem von einem Glasmaterial, einem Metallmaterial, einem Polymermaterial und einem Keramikmaterial gebildet ist.

3. Lichtemittierendes Bauelement nach Anspruch 1, wobei jede der mehreren Wandungen (310a) der Umfriedungsstruktur (300a) angrenzend an einen anderen Rand des Substrats (500a) gebildet ist.

4. Lichtemittierendes Bauelement nach Anspruch 1, wobei die reflektierende Schicht (1310) einen Film aus anorganischem reflektierendem Material umfasst.

5. Lichtemittierendes Bauelement nach Anspruch 1, wobei die Umfriedungsstruktur (300a) auf eine zweite Oberfläche des Substrats (500a) über ein Bondiermuster (710) montiert ist, das zumindest teilweise mit einer Grundfläche der Umfriedungsstruktur (300a) übereinstimmt.

6. Lichtemittierendes Bauelement nach Anspruch 1, ferner eine Lichtdiffusionsstruktur umfassend, die in der Zelle (310b) angeordnet ist, wobei die Lichtdiffusionsstruktur dazu eingerichtet ist, sekundäres Licht zu streuen, das von der Lichtumwandlungsstruktur (912) emittiert wird.

7. Lichtemittierendes Bauelement nach Anspruch 1, ferner einen Kontakt (512) umfassend, der auf der LED (510) gebildet ist.

8. Lichtemittierendes Bauelement nach Anspruch 1, wobei ein Bondiermuster (710) auf den reflektierenden Linien (612, 612a) gebildet ist und wobei die Umfriedungsstruktur (300a) an der Bondierschicht (710) montiert ist.

9. Lichtemittierendes Bauelement nach Anspruch 8, wobei das Bondiermuster eine Breite aufweist, die größer als eine Breite der reflektierenden Linien (612, 612a) ist.

10. Lichtemittierendes Bauelement nach Anspruch 8, wobei die Umfriedungsstruktur (300a) aus mindestens einem von einem Glasmaterial, einem Metallmaterial, einem Polymermaterial und einem Keramikmaterial gebildet ist.

11. Lichtemittierendes Bauelement nach Anspruch 8, wobei jede der mehreren Wandungen (310a) der Umfriedungsstruktur (300a) angrenzend an einen anderen Rand des Substrats (500a) gebildet ist.

12. Lichtemittierendes Bauelement nach Anspruch 8, wobei das reflektierende Element (410a) oder die reflektierende Schicht (1310) einen Film aus anorganischem reflektierendem Material umfasst.

13. Lichtemittierendes Bauelement nach Anspruch 8, ferner eine Lichtdiffusionsstruktur umfassend, die in der Zelle (310b) angeordnet ist, wobei die Lichtdiffusionsstruktur dazu eingerichtet ist, sekundäres Licht zu streuen, das von der Lichtumwandlungsstruktur (912) emittiert wird.

14. Lichtemittierendes Bauelement nach Anspruch 8, ferner einen Kontakt (512) umfassend, der auf der LED (510) gebildet ist.

15. Verfahren zum Herstellen eines lichtemittierenden Bauelements nach einem der Ansprüche 1 bis 14, wobei das Verfahren Folgendes umfasst:
Bilden mehrerer Leuchtdioden (LEDs 510) auf einer ersten Oberfläche (502) eines Wafers (500),
Bilden einer Umfriedungsstruktur (300), die mehrere Wandungen (310) beinhaltet, die dazu eingerichtet sind, mehrere Zellen (320) zu definieren,
Koppeln der Umfriedungsstruktur (300) mit einer zweiten Oberfläche des Wafers (500), die gegenüber der ersten Oberfläche liegt, durch Fluchten jeder der mehreren Zellen (320) mit einer anderen der mehreren LEDs (510),
Aufbringen eines Lichtumwandlungsmaterials auf die zweite Oberfläche des Wafers (500), um in jeder der mehreren Zellen (320) eine andere entsprechende Lichtumwandlungsstruktur (912) zu bilden,
Längsschneiden der Wandungen (310) der Umfriedungsstruktur (300) und von Abschnitten des Wafers, die mit den Wandungen (310) der Umfriedungsstruktur (300) gekoppelt sind, um mehrere lichtemittierende Bauelemente zu bilden,
Bilden einer reflektierenden Schicht (1310) auf jedem der lichtemittierenden Bauelemente und
Bilden eines reflektierenden Musters (610) auf einer zweiten Oberfläche (504) des Wafers (500) vor dem Koppeln der Umfriedungsstruktur (300) mit der zweiten Oberfläche des Wafers (500), wobei das reflektierende Muster (610) mehrere reflektierende Linien (612, 612a) umfasst, die im Wesentlichen mit einer Grundfläche der Umfriedungsstruktur (300) übereinstimmen.

## Revendications

1. Dispositif électroluminescent (1210), comprenant :
un substrat (500a) ;
une diode électroluminescente (LED 510) formée sur une première surface du substrat (500a), la LED (510) étant prévue pour émettre une lumière principale,
une structure de barrière (300a) montée sur une seconde surface du substrat (500a), la structure de barrière (300a) comprenant une pluralité de parois (310a) prévues pour définir une cellule (310b), un motif réfléchissant (610) formé sur la seconde surface du substrat (500a), le motif réfléchissant (610) comprenant une pluralité de lignes (612, 612a), chaque ligne (612, 612a) étant au moins partiellement coïncidente avec une paroi différente (310a) de la structure de barrière (300a) ;
une structure de conversion de la lumière (912) disposée sur la seconde surface du substrat (500a) dans la cellule (310b), la structure de conversion de la lumière étant prévue pour convertir au moins une partie de la lumière principale en une lumière secondaire ayant une longueur d'onde qui est différente de la longueur d'onde de la lumière principale ; et
une couche réfléchissante (1310) formée sur une surface externe de la pluralité de parois (310a) de la structure de barrière (300a), des parois latérales du substrat (500a), et des parois latérales de la LED (510), de sorte que la couche réfléchissante (1310) et la structure de conversion de la lumière (912) soient disposées sur les côtés opposés des parois (310a) de la structure de barrière (300a).

2. Dispositif électroluminescent selon la revendication 1, dans lequel la structure de barrière (300a) est formée d'au moins l'un d'un matériau en verre, d'un matériau en métal, d'un matériau polymère, et d'un matériau en céramique.

3. Dispositif électroluminescent selon la revendication 1, dans lequel chacune de la pluralité de parois (310a) de la structure de barrière (300a) est formée de manière adjacente à un bord différent du substrat (500a).

4. Dispositif électroluminescent selon la revendication 1, dans lequel la couche réfléchissante (1310) comprend un film de matériau réfléchissant inorganique.

5. Dispositif électroluminescent selon la revendication 1, dans lequel la structure de barrière (300a) est montée sur la seconde surface du substrat (500a) via un motif de liaison (710) qui correspond au moins partiellement à une empreinte de la structure de barrière (300a).

6. Dispositif électroluminescent selon la revendication 1, comprenant en outre une structure de diffusion de la lumière disposée dans la cellule (310b), la structure de diffusion de la lumière étant prévue pour diffuser la lumière secondaire qui est émise par la structure de conversion de la lumière (912).

7. Dispositif électroluminescent selon la revendication 1, comprenant en outre un contact (512) formé sur la LED (510).

8. Dispositif électroluminescent selon la revendication 1, dans lequel un motif de liaison (710) est formé sur les lignes réfléchissantes (612, 612a), et dans lequel la structure de barrière (300a) est montée sur la couche de liaison (710).

9. Dispositif électroluminescent selon la revendication 8, dans lequel le motif de liaison possède une largeur supérieure à une largeur des lignes réfléchissantes (612, 612a).

10. Dispositif électroluminescent selon la revendication 8, dans lequel la structure de barrière (300a) est formée d'au moins l'un d'un matériau en verre, d'un matériau en métal, d'un matériau polymère, et d'un matériau en céramique.

11. Dispositif électroluminescent selon la revendication 8, dans lequel chacune de la pluralité de parois (310a) de la structure de barrière (300a) est formée de manière adjacente à un bord différent du substrat (500a).

12. Dispositif électroluminescent selon la revendication 8, dans lequel l'élément réfléchissant (410a) ou la couche réfléchissante (1310) comprend un film de matériau réfléchissant inorganique.

13. Dispositif électroluminescent selon la revendication 8, comprenant en outre une structure de diffusion de la lumière disposée dans la cellule (310b), la structure de diffusion de la lumière étant prévue pour diffuser la lumière secondaire qui est émise par la structure de conversion de la lumière (912).

14. Dispositif électroluminescent selon la revendication 8, comprenant en outre un contact (512) formé sur la LED (510).

15. Procédé de fabrication du dispositif électroluminescent selon l'une des revendications 1 à 14, le procédé comprenant :
la formation d'une pluralité de diodes électroluminescentes (LED 510) sur une première surface (502) d'une tranche (500) ;
la formation d'une structure de barrière (300) comprenant une pluralité de parois (310) qui sont prévues pour définir une pluralité de cellules (320) ;
le couplage de la structure de barrière (300) à une seconde surface de la tranche (500) qui est opposée à la première surface en alignant chacune de la pluralité de cellules (320) avec l'une de la pluralité de LED (510) ;
l'application d'un matériau de conversion de la lumière sur la seconde surface de la tranche (500) afin de former une structure de conversion de la lumière respective différente (912) dans chacune de la pluralité de cellules (320) ;
la découpe longitudinale des parois (310) de la structure de barrière (300) et des parties de la tranche qui sont couplées aux parois (310) de la structure de barrière (300) afin de former une pluralité de dispositifs électroluminescents ;
la formation d'une couche réfléchissante (1310) sur chacun des dispositifs électroluminescents ;
et
la formation d'un motif réfléchissant (610) sur une seconde surface (504) de la tranche (500) avant de coupler la structure de barrière (300) à la seconde surface de la tranche (500), le motif réfléchissant (610) comprenant une pluralité de lignes réfléchissantes (612, 612a) qui correspondent sensiblement à une empreinte de la structure de barrière (300).
